# EUROPEAN PATENT SPECIFICATION

(11) **EP 2 931 679 B1**
(45) Date of publication and mention of the grant of the patent: **30.10.2019**
(21) Application number: 14772481.9
(22) Date of filing: 11.03.2014
(51) Int. Cl.: C04B 35/565, C04B 35/628, C04B 35/80

(54) **COMPOSITE COMPONENTS WITH COATED FIBER REINFORCEMENTS**
VERBUNDKOMPONENTEN MIT BESCHICHTETEN FASERVERSTÄRKUNGEN
COMPOSANTS COMPOSITES POURVUS DE RENFORTS EN FIBRES GAINÉES

(30) Priority: 13.03.2013 US 201361779590 P
(43) Date of publication of application: 21.10.2015
(73) Proprietor: Rolls-Royce Corporation, Indianapolis, Indiana 46225 (US)
(72) Inventor: CHAMBERLAIN, Adam L., Indiana 46158 (US); LANDWEHR, Sean E., Indiana 46123 (US)
(74) Representative: Friese Goeden Patentanwälte PartGmbB
(86) International application number: PCT/US2014/023046
(87) International publication number: WO 2014/197036

(56) References cited:
- US-A- 4 072 516
- US-A- 6 077 605
- US-B1- 6 322 889
- SHIMOO T ET AL: "SYNTHESIS OF C-SIC COMPOSITE FIBER BY PRECURSOR METHOD", JOURNAL OF THE CERAMIC SOCIETY OF JAPAN, INTERNATIONAL EDITION, FUJI TECHNOLOGY PRESS, TOKYO, JP, vol. 102, no. 9, 1 September 1994 (1994-09-01), pages 878-884, XP000495862, ISSN: 0912-9200

## Description

### FIELD OF THE DISCLOSURE

The present disclosure relates generally to composite materials including fibers suspended in a matrix material. More specifically, the present disclosure relates to coatings for fibers included in ceramic matrix composites that are used in high-temperature mechanical systems such as gas turbine engines.

### BACKGROUND

A gas turbine engine, such as an aircraft engine, operates in severe environments. Ceramic matrix composite (CMC) components have desirable high temperature mechanical, physical, and chemical properties which allow gas turbine engines to operate at much higher temperatures than current engines with superalloy components. For example, CMC components exhibit a significant amount of damage tolerance when under an applied load when compared to superalloy components. This damage tolerance is due in part to the formation of multiple matrix cracks that aid in the redistribution of stresses.

An issue with CMC components, however, is their lack of environmental durability in combustion environments. For example, the formation of matrix cracks may result in environmental exposure to the fiber and fiber interface coating (typically boron nitride (BN)), which over time, may cause environmental degradation of the CMCs. The environmental degradation of CMCs is temperature and environment dependent. For example, at low temperatures (e.g., below 1000°C) oxygen may ingress to the fiber unimpeded causing environmental attack at the interface and resulting in embrittlement. At high temperatures (e.g., greater than 1000°C), silicon dioxide (SiO₂) may be formed, which may impede oxygen transport and slow down the degradation of the fiber and the fiber interface. However, the formation of SiO₂ may be hindered if water vapor (a combustion reaction product) is present.

US 6,077,605 A relates to silica and/or silicate containing coatings upon particles, fibers, powders, among other substrates. The solubility of the coating can be modified by being treated with a metal chloride.

US 4,072,516 A discloses a novel graphite fiber/metal composite material in which the graphite fibers have an adherent coating of silicon oxide and silicon carbide. The coating protects the graphite surface from attack by carbide forming matrix metals such as aluminum, titanium, magnesium and nickel.

T. Shimoo, M Takemura, K. Okamura, Y. Kurachi, M. Kajiwara: "Synthesis of C-SiC Composite Fiber by precursor Method"; Journal of the ceramic society of Japan, Vol. 102, No. 9 (1994) 878-884 discloses a C-SiC composite fiber. This fiber was obtained by heating a C-Si02 precursor, prepared from carbon fiber impregnated with ethylsilicate.

From US 6,322,889 B1 a ceramic-matrix composite is known having a multilayered interfacial coating adapted to protect the reinforcing fibers from long-term oxidation, while allowing these to bridge the wake of advancing cracks in the matrix.

### SUMMARY

According to the present disclosure, a method of making a reinforcement for a composite component includes depositing an oxide coating onto a fiber. The method also includes depositing a silicon-containing coating onto the oxide coating.

The method also includes heating the coated fiber to a predetermined temperature. Heating the coated fiber forms a predetermined amount of silicate in the silicon-containing coating at the interface of the oxide coating and the silicon-containing coating.

In some embodiments, heating the coated fiber to a predetermined temperature to form a predetermined amount of silicate at the interface of the oxide coating and the silicon-containing coating may be performed for a predetermined amount of time in a furnace. The predetermined temperature is between 800 and 1500 degrees Celsius.

In some embodiments, the silicate formed at the interface of the oxide coating and the silicon-containing coating may include silicon dioxide. The silicon-containing coating may have a porosity by volume of between 10 percent and 20 percent. The oxide coating may have a porosity by volume of between 10 percent and 20 percent. The fiber includes silicon carbide and the silicon-containing coating includes silicon carbide.

According to another aspect of the present disclosure, a reinforcement for a composite component includes a fiber and a multilayer coating. The multilayer coating includes an oxide coating and a silicon-containing coating in contact with the oxide coating to form an interface between the oxide coating and the silicon-containing coating.

A silicate is formed at the interface of the oxide coating and the silicon-containing coating. The silicate is formed by heating of the fiber, the oxide coating, and the silicon-containing coating to a predetermined temperature so that a predetermined amount of silicate is produced.

The predetermined temperature is greater than 800 degrees Celsius. The silicate formed at the interface of the oxide coating and the silicon-containing coating may include silicon dioxide.

In some embodiments, the silicon-containing coating may have a porosity by volume of between 10 percent and 20 percent. The oxide coating may have a porosity by volume of between 10 percent and 20 percent. The fiber includes silicon carbide and the silicon-containing coating includes silicon carbide.

According to another aspect of the present disclosure, a method of making a composite component includes preparing reinforcements and suspending the reinforcements in a matrix material. Preparing reinforcements is performed by depositing an oxide coating and depositing a silicon-containing coating onto the oxide coating.

The method includes heating the reinforcements to a predetermined temperature to form a controlled amount of silicate. The silicate is formed at the interface of the oxide coating and the silicon-containing coating.

In some embodiments, heating the coated fiber to a predetermined temperature to form a predetermined amount of silicate at the interface of the oxide coating and the silicon-containing coating may be performed for a predetermined amount of time in a furnace. The predetermined temperature is greater than 800 degrees Celsius.

Heating the reinforcements to a predetermined temperature is performed before suspending the reinforcements in a matrix material. The silicon-containing coating includes silicon carbide and the fiber includes silicon carbide. The matrix material may also include silicon carbide.

According to another aspect of the present disclosure, a composite component includes a matrix material and a plurality of reinforcements. Each reinforcement includes a fiber, an oxide coating, and a silicon-containing coating.

The silicon-containing coating is arranged in contact with the oxide coating to form an interface. A silicate is formed at the interface by heating of the fiber, the oxide coating, and the silicon-containing coating to a predetermined temperature so that a predetermined amount of silicate is produced.

The predetermined temperature is greater than 800 degrees Celsius. The silicate formed at the interface of the oxide coating and the silicon-containing coating may include silicon dioxide.

In some embodiments, the silicon-containing coating may have a porosity by volume of between 10 percent and 20 percent. The oxide coating may have a porosity by volume of between 10 percent and 20 percent. In some embodiments, the matrix material, the fiber, and/or the silicon-containing coating may each include silicon carbide.

These and other features of the present disclosure will become more apparent from the following description of the illustrative embodiments.

### BRIEF DESCRIPTION OF THE DRAWINGS

Fig. 1 is a perspective view of a composite component including a plurality of reinforcements suspended in a cured matrix material;
Fig. 2 is a cross-sectional view of a reinforcements included in the composite component suspended in the cured matrix material of Fig. 1 illustrating that the reinforcement includes a fiber coated with a multilayer interface coating;
Fig. 3 is a block diagram of a method of making the composite component of Figs. 1 and 2 showing that the method includes preparing reinforcements for use in the composite component; and
Fig. 4 is a block diagram showing a method of preparing reinforcements for use in the method of making the composite component illustrated in Fig. 3 showing that the method of preparing reinforcements includes depositing an oxide coating and a silicon-containing coating onto a fiber and heating the coated fiber to form a silicate in the silicon-containing coating at the interface of the silicon-containing coating and the oxide coating.

### DETAILED DESCRIPTION OF THE DRAWINGS

For the purposes of promoting an understanding of the principles of the disclosure, reference will now be made to a number of illustrative embodiments illustrated in the drawings and specific language will be used to describe the same.

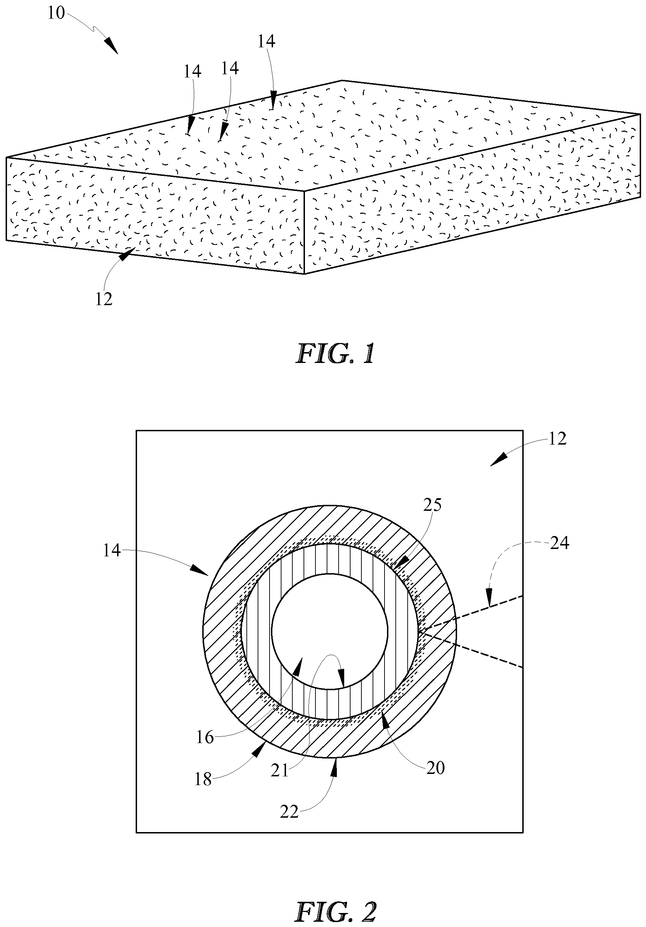

An illustrative composite component 10 adapted for use in high temperature applications such as a gas turbine engine is shown in Fig. 1. The composite component 10 illustratively includes a matrix material 12 and a plurality of reinforcements 14. The matrix material 12 illustratively comprises silicon carbide (SiC) so that the exemplary composite component 10 is a ceramic matrix composite (CMC). Each of the reinforcements 14 includes a fiber 16 comprising silicon carbide (SiC) so that the exemplary composite component 10 is a silicon-carbide silicon-carbide (SiC-SiC) component. The composition of the composite component 10 provides high temperature capability. In addition to a fiber 16, each reinforcement 14 includes a multilayer coating 18 applied to a corresponding fiber 16 as shown in Fig. 2. The multilayer coating 18 is formulated and treated during production of the composite component 10 so that a predetermined amount of silicate 20 (illustratively silicon dioxide (SiO₂)) is formed at an interface 25 of two coating layers 21, 22 included in the multilayer coating 18 before the reinforcement 14 is incorporated into the composite component 10. The silicate 20 formed in the multilayer coating 18 improves the water vapor stability of the reinforcements 14 to extend the life of the composite component 10 if a crack 24 forming in the composite component 10 extends through the matrix material 12 and into the reinforcements 14 during use of the composite component 10.

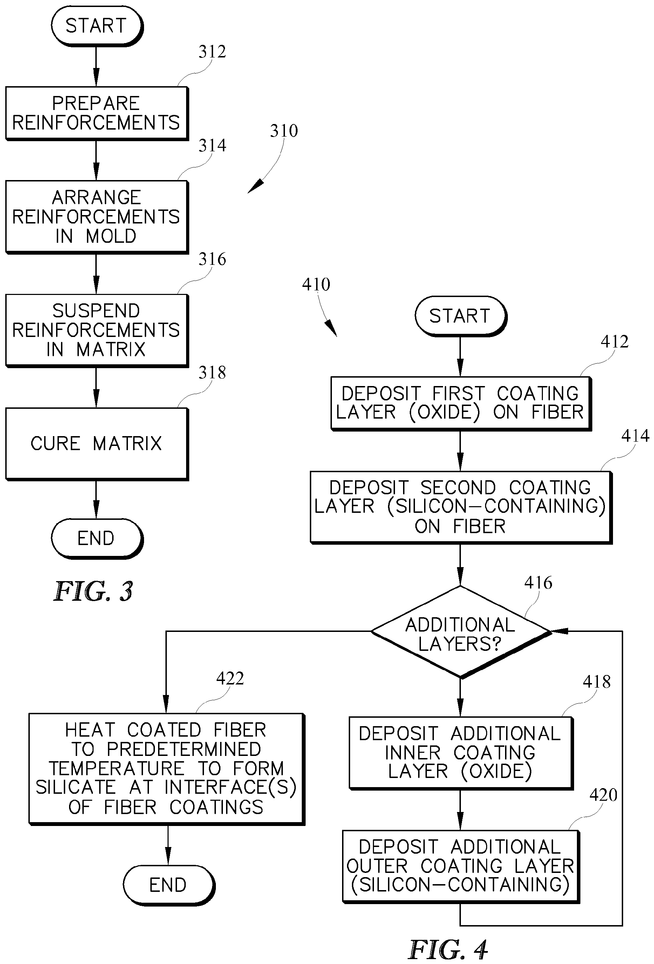

In order to produce the silicate 20, the multilayer coating 18 includes a first layer of coating 21 that comprises an oxide and a second layer of coating 22 that comprises a silicon-containing compound as suggested in Figs. 2 and 4. The first layer 21 is deposited directly onto the fiber 16 and provides a weak interface with the fiber 16 to allow for fiber debonding. The second layer 22 is deposited onto the first layer of coating 21 so that the interface 25 is created between the first and second layers of coating 21, 22.

In some embodiments, additional paired coating layers (not shown) of oxide coating and silicon-containing coating may be applied over the first and second paired layers 21, 22 to create additional interfaces at which silicate is formed during preparation of a reinforcement 14 as suggested in Fig. 4. In some embodiments, up to fifty layers of paired coating layers may be included in the multilayer coating 18. Further, in some embodiments, other coating layers may be applied to the fiber 16 before the first layer 21 and/or at regular or irregular intervals between paired oxide/silicon-containing coating layers in the multilayer interface coating 18. For example, other coating layers included in multilayer coating 18 may comprise boron nitride. However, the outermost layer of the multilayer interface coating 18 is not boron nitride.

The first layer 21 illustratively includes a stable rare earth oxide and may be selected from the group including Yttrium(III), Ytterbium oxide, Erbium(III), Lutetium(III), and Dysprosium(III). The first layer 21 has a thickness of between about 25 nanometers and 100 nanometers. In some embodiments, the first layer 21 may include a single phase transition metal oxide. Exemplary single phase transition metal oxides may include transition metals such as Zirconium, Halfnium, etc. along with oxygen (e.g. ZrO₂, HfO₂, etc.). In some embodiments, the first layer 21 may include a mixed oxide (e.g. Y₂O₃·ZrO₂, Yb₂O₃·HfO₂, etc.).

The oxide-containing first layer of coating 21 illustratively has a porosity of between 10 to 20 percent by volume. The porosity of the first layer 21 encourages deflection of a crack 24 that extends through the matrix material 12 and into the reinforcements 14 during use of the composite component 10. In other embodiments, the first layer 21 may be dense (non-porous).

The oxide-containing first layer 21 of multilayer coating 18 may impede and/or prevent the formation of oxide products (e.g., oxidation) during use of the composite component 10 in environments between 800 and 1000 degrees Celsius. Thus, the first layer 21 of multilayer coating 18 may prevent and/or reduce embrittlement of the reinforcements 14 when the composite component 10 is in use.

The second layer 22 includes silicon carbide deposited onto the first layer 21 to create the interface 25 as shown in Fig. 2. The second layer 22 has a thickness of between 25 nanometers and 100 nanometers. In some embodiments, the second layer 22 may include other silicon-containing compounds.

The silicon-containing second layer of coating 22 illustratively has a porosity of between 10 to 20 percent by volume. The porosity of the second layer 22 encourages deflection of a crack 24 that extends through the matrix material 12 and into the reinforcements 14 during use of the composite component 10. In other embodiments, the second layer 22 may be dense (non-porous).

The silicate 20 is formed in the second layer 22 as a result of heating the multilayer coating 18 included in the reinforcement 14 to cause the silicon-containing second layer 22 to react with the oxide-containing first layer 21 at the interface 25 as shown in Fig. 2. As noted above, the silicate 20 formed in the exemplary embodiment includes silicon dioxide (SiO₂) that improves the water vapor stability of the reinforcements 14. The silicate 20 is formed by heating the fiber 16 and the multilayer coating 18 to a predetermined temperature for a predetermined amount of time so that a predetermined (desired) amount of silicate is formed at the interface 25 prior to incorporation of the reinforcements 14 into the composite component 10. In the illustrative embodiment, the silicate 20 is formed by heating the multilayer coating 18 to a temperature between 800 degrees Celsius and 1500 degrees Celsius for more than one hour.

In the illustrative embodiment, the fibers 16 are chopped fibers as shown in Fig. 1. In other embodiments, the fibers 16 may be woven, braided, or otherwise processed in addition to being coated by the multilayer coating 18. For purposes of this disclosure, "fiber" or "fibers" may refer to fibers, filaments, whiskers, tows, cloth and combinations thereof.

Turning now to Fig. 3 a method 310 for making the composite component 10 is shown. In a step 312 of method 310, the reinforcements 14 are prepared as shown in more detail in Fig. 4. In a step 314, the reinforcements 14 are arranged in a mold. In a step 316, the matrix material 12 is poured into the mold to preliminarily suspend the reinforcements 14. The order of step 314 and step 316 may be reversed and the steps may be repeated a number of times to distribute the reinforcements 14 as desired. In a step 316, the matrix material 12 is cured to harden/finish the composite component 10. Curing the matrix material 12 in step 316 is illustratively performed by heating the matrix material 12 to a temperature generally under 800 degrees Celsius in a controlled-atmosphere furnace.

Fig. 4 shows a method 410 of preparing the reinforcements 14 for use in the method 310 shown in Fig. 3. In a step 412 of method 410, the first layer 21 is deposited onto the fiber 16. In a step 414 of method 410, the second layer 22 is deposited onto first layer 21. After the first two layers 21, 22 are deposited, it is determined if additional coating layers are desirable in a decision step 416.

When additional layers are found to be desired in decision step 416, an additional inner coating layer including an oxide is deposited in a step 418 and an additional outer coating layer including a silicon-containing compound is deposited in a step 420. After step 420, the decision step 416 is repeated and additional paired layers are deposited onto the fiber 16 until no additional layers are desired.

In some embodiments, additional steps for depositing intervening layers of coating may also be performed as part of the method 410. For example, coating layers comprising boron nitride (or other materials) may be deposited as part of the multilayer coating 18.

When additional layers are not found to be desired in decision step 416, the coated fiber is heated in a step 422 to a predetermined temperature for a predetermined amount of time in a furnace as shown in Fig. 4. Heating the coated fiber forms a predetermined amount of silicate 20 in the silicon-containing second layer 22 at the interface 25 with the oxide-containing first layer 21. Additional silicate is formed at the interface of additional silicon-containing layers and oxide-containing layers deposited onto the fiber 16. In some embodiments of the method 410, step 422 may be omitted on account of expected silicate formation during use of the composite component 10.

During use of the composite component 10 in a high temperature environment, silicate formation can take place when a crack 24 in the matrix material 12 propagates to the multilayer coating 18 of the reinforcements 14 and when temperatures are above 1000 degrees Celsius. Particularly, when operating temperatures of the composite component 10 are above 1000 degrees Celsius and the multilayer coating 18 is exposed to the high-temperature environment as a result of a crack 24, a silicate 20 containing silicon dioxide (SiO₂) may be formed in the silicon-containing second layer 22 of the multilayer coating 18. The silicate 20 formed in the silicon-containing second layer 22 may be added to silicate 20 formed during preparation of the reinforcements 14. Any silicate 20 included in the multilayer coating 18 may slow down the propagation of oxygen to the fiber 16 or the fiber interface with the multilayer coating 18 prolonging the life of the composite component 10. In addition, the silicate 20 may improve the water vapor stability of the reinforcement 14 and, as a result, may improve life of the composite component 10.

In step 412, the first layer 21 is illustratively deposited using a chemical vapor infiltration technique. Standard chemical vapor infiltration, metal organic chemical infiltration, ultraviolet assisted chemical vapor infiltration, physical vapor deposition, or directed vapor deposition are all contemplated methods of depositing oxide-containing layers onto the fiber 16.

In a related embodiments, during step 412, the first layer 21 may be formed by deposition of a carbide, nitride, or carbonitride of the transition metal or rare earth material, or a combination thereof (e.g. ZrC, ZrCₓN₁₋ₓ, HfCₓN₁₋ₓ, YC₂, YN, YbN, HfₓY_{y}C_{z}N_{1-z}, etc) and a subsequent heat treatment to form a dense or porous oxide layer. The non-oxide coating could also be oxidized (usually forming a porous layer) through normal use at temperatures below 1000 degrees Celsius.

In step 414, the second layer 22 is illustratively deposited using a chemical vapor infiltration technique. Standard chemical vapor infiltration, metal organic chemical infiltration, ultraviolet assisted chemical vapor infiltration, physical vapor deposition, or directed vapor deposition are all contemplated methods of depositing oxide-containing layers onto the first layer 21.

In step 422, heating of the coated fibers is performed at temperatures between 800 degrees Celsius and 1500 degrees Celsius. Further, the coated fibers are heated for more than one hour.

In some embodiments, prior to use of the composite component 10 in a high-temperature application, the component 10 may be machined into a particular shape for use as a turbine blade track, a turbine blade, a combustion liner, a heat shield tile or the like. In some embodiments, the composite component 10 may be shaped in the mold to for use in its final application.

## Claims

1. A method of making a reinforcement for a composite component, the method comprising
depositing an oxide coating onto a silicon carbide containing fiber, depositing a silicon-containing coating, the silicon-containing coating including silicon carbide, onto the oxide coating, and
heating the coated fiber to a predetermined temperature between 800 and 1500 degrees Celsius to form a predetermined amount of a silicate in the silicon-containing coating at the interface of the oxide coating and the silicon-containing coating.

2. The method of claim 1, wherein heating the coated fiber to the predetermined temperature to form a predetermined amount of a silicate in the silicon containing coating at the interface of the oxide coating and the silicon-containing coating is performed for a predetermined amount of time in a furnace.

3. The method of claim 1 or 2, wherein the silicate formed in the silicon containing coating at the interface of the oxide coating and the silicon-containing coating includes silicon dioxide, the silicon- containing coating has a porosity by volume of between 10 percent and 20 percent, and the oxide coating has a porosity by volume of between 10 percent and 20 percent.

4. A reinforcement for a composite component comprising a silicon carbide containing fiber, a multilayer coating including an oxide coating on the silicon carbide containing fiber and a silicon-containing coating in contact with the oxide coating to form an interface, the silicon-containing coating including silicon carbide, and a silicate formed in the silicon-containing coating at the interface by heating of the fiber, the oxide coating, and the silicon-containing coating to a predetermined temperature between 800 and 1500 degrees Celsius so that a predetermined amount of silicate is produced.

5. The reinforcement of claim 4, wherein the silicate formed in the silicon-containing coating at the interface of the oxide coating and the silicon-containing coating includes silicon dioxide, the silicon-containing coating has a porosity by volume of between 10 percent and 20 percent, and the oxide coating has a porosity by volume of between 10 percent and 20 percent..

6. A method of making a composite component comprising preparing reinforcements by depositing an oxide coating and depositing a silicon-containing coating onto the oxide coating, each reinforcement comprising a silicon carbide containing fiber, the oxide coating being deposited on the silicon carbide containing fiber, and the silicon-containing coating including silicon carbide, heating the reinforcements to a predetermined temperature between 800 and 1500 degrees Celsius to form a controlled amount of a silicate in the silicon-containing coating at the interface of the oxide coating and the silicon-containing coating, and suspending the reinforcements in a matrix material.

7. The method of claim 6, wherein heating the coated fiber to the predetermined temperature to form a predetermined amount of a silicate in the silicon-containing coating at the interface of the oxide coating and the silicon-containing coating is performed for more than one hour in a furnace.

8. The method of any one of claims 6 to 7 wherein the matrix material includes silicon carbide.

9. A composite component comprising a matrix material, and a plurality of reinforcements, each reinforcement including a silicon carbide containing fiber, an oxide coating on the silicon carbide containing fiber, and a silicon-containing coating including silicon carbide, wherein the silicon-containing coating is in contact with the oxide coating to form an interface and a silicate is formed in the silicon-containing coating at the interface by heating of the fiber, the oxide coating, and the silicon-containing coating to a predetermined temperature between 800 and 1500 degrees Celsius so that a predetermined amount of silicate is produced.

10. The composite component of claim 9, wherein the silicate formed in the silicon-containing coating at the interface of the oxide coating and the silicon-containing coating includes silicon dioxide, the silicon-containing coating has a porosity by volume of between 10 percent and 20 percent, and the oxide coating has a porosity by volume of between 10 percent and 20 percent.

11. The composite component of claim 9 or 10, wherein the matrix material includes silicon carbide.

## Patentansprüche

1. Verfahren zum Herstellen einer Verstärkung für eine Verbundkomponente, wobei das Verfahren umfasst:
Abscheiden einer Oxidschicht auf einer Siliziumkarbid enthaltenden Faser, Abscheiden einer Silizium enthaltenden Schicht, wobei die Silizium enthaltende Schicht Siliziumcarbid aufweist, auf der Oxidschicht, und Erwärmen der beschichteten Faser auf eine vorbestimmte Temperatur zwischen 800 und 1500°C, um eine vorbestimmte Menge eines Silikats in der Silizium enthaltenden Schicht an der Grenzfläche zwischen der Oxidschicht und der Silizium enthaltenden Schicht zu bilden.

2. Verfahren nach Anspruch 1, wobei das Erwärmen der beschichteten Faser auf die vorbestimmte Temperatur, um eine vorbestimmte Menge eines Silikats in der Silizium enthaltenden Schicht an der Grenzfläche zwischen der Oxidschicht und der Silizium enthaltenden Schicht zu bilden, für eine vorbestimmte Zeitdauer in einem Ofen durchgeführt wird.

3. Verfahren nach Anspruch 1 oder 2, wobei das in der Silizium enthaltenden Schicht an der Grenzfläche zwischen der Oxidschicht und der Silizium enthaltenen Schicht gebildete Silikat Siliziumdioxid aufweist, die Silizium enthaltende Schicht eine Volumenporosität zwischen 10 % und 20 % hat und die Oxidschicht eine Volumenporosität zwischen 10 % und 20 % aufweist.

4. Verstärkung für eine Verbundkomponente, umfassend eine Siliziumkarbid enthaltende Faser,
einen mehrschichtigen Überzug, der eine Oxidschicht auf der Siliziumkarbid enthaltenden Faser und eine Silizium enthaltende Schicht in Kontakt mit der Oxidschicht unter Bildung einer Grenzfläche aufweist, wobei die Silizium enthaltende Schicht Siliziumkarbid aufweist, und
ein Silikat, das in der Silizium enthaltenden Schicht an der Grenzfläche durch Erwärmen der Faser, der Oxidschicht und der Silizium enthaltenden Schicht auf eine vorbestimmte Temperatur zwischen 800 und 1500°C gebildet wird, so dass eine vorbestimmte Menge an Silikat erzeugt wird.

5. Verstärkung nach Anspruch 4, wobei das in der Silizium enthaltenden Schicht an der Grenzfläche zwischen der Oxidschicht und der Silizium enthaltenden Schicht gebildete Silikat Siliziumdioxid aufweist, die Silizium enthaltende Schicht eine Volumenporosität zwischen 10 % und 20 % hat und die Oxidschicht eine Volumenporosität zwischen 10 % und 20 % aufweist.

6. Verfahren zum Herstellen einer Verbundkomponente, umfassend:
Herstellen von Verstärkungen durch Abscheiden einer Oxidschicht und Abscheiden einer Silizium enthaltenden Schicht auf der Oxidschicht,
wobei jede Verstärkung eine Siliziumkarbid enthaltende Faser umfasst, die Oxidschicht auf der Siliziumkarbid enthaltenden Faser abgeschieden wird und die Silizium enthaltende Schicht Siliziumkarbid aufweist,
Erwärmen der Verstärkungen auf eine vorbestimmte Temperatur zwischen 800 und 1500°C, um eine kontrollierte Menge eines Silikats in der Silizium enthaltenden Schicht an der Grenzfläche zwischen der Oxidschicht und der Silizium enthaltenden Schicht zu bilden, und
Einhängen der Verstärkungen in ein Matrixmaterial.

7. Verfahren nach Anspruch 6, wobei das Erwärmen der beschichteten Faser auf die vorbestimmte Temperatur, um eine vorbestimmte Menge eines Silikats in der Silizium enthaltenden Schicht an der Grenzfläche zwischen der Oxidschicht und der Silizium enthaltenden Schicht zu bilden, für mehr als eine Stunde in einem Ofen durchgeführt wird.

8. Verfahren nach einem der Ansprüche 6 bis 7, wobei das Matrixmaterial Siliziumkarbid aufweist.

9. Verbundkomponente, umfassend ein Matrixmaterial und eine Vielzahl von Verstärkungen, wobei jede Verstärkung eine Siliziumkarbid enthaltende Faser, eine Oxidschicht auf der Siliziumkarbid enthaltenden Faser und eine Silizium enthaltende Schicht, die Siliziumkarbid aufweist, umfasst,
wobei die Silizium enthaltende Schicht mit der Oxidschicht in Kontakt steht, um eine Grenzfläche zu bilden, und ein Silikat in der Silizium enthaltenden Schicht an der Grenzfläche durch Erwärmen der Faser, der Oxidschicht und der Silizium enthaltenden Schicht auf eine vorbestimmte Temperatur zwischen 800 und 1500°C gebildet wird, so dass eine vorbestimmte Menge an Silikat erzeugt wird.

10. Verbundkomponente nach Anspruch 9, wobei das in der Silizium enthaltenden Schicht an der Grenzfläche zwischen der Oxidschicht und der Silizium enthaltenden Schicht gebildete Silikat Siliziumdioxid aufweist, die Silizium enthaltende Schicht eine Volumenporosität zwischen 10 % und 20 % hat und die Oxidschicht eine Volumenporosität zwischen 10 % und 20 % aufweist.

11. Verbundkomponente nach Anspruch 9 oder 10, wobei das Matrixmaterial Siliziumkarbid aufweist.

## Revendications

1. Procédé pour réaliser un renforcement pour un composant composite, le procédé comprenant les étapes consistant à
déposer un revêtement d'oxyde sur un carbure de silicium contenant des fibres,
déposer un revêtement contenant du silicium, le revêtement contenant du silicium incluant du carbure de silicium, sur le revêtement d'oxyde, et chauffer les fibres revêtues à une température prédéterminée entre 800 et 1500 °C pour former une quantité prédéterminée de silicate dans le revêtement contenant du silicium au niveau de l'interface du revêtement d'oxyde et du revêtement contenant du silicium.

2. Procédé selon la revendication 1, dans lequel le chauffage des fibres revêtues à la température prédéterminée pour former une quantité prédéterminée de silicate dans le revêtement contenant du silicium au niveau de l'interface du revêtement d'oxyde et du revêtement contenant du silicium est exécuté pendant un temps prédéterminé dans un four.

3. Procédé selon la revendication 1 ou 2, dans lequel silicate formé dans le revêtement contenant du silicium au niveau de l'interface du revêtement d'oxyde et du revêtement contenant du silicium inclut du dioxyde de silicium, le revêtement contenant du silicium présente une porosité en volume entre 10 % et 20 %, et le revêtement d'oxyde présente une porosité en volume entre 10 % et 20 %.

4. Renforcement pour un composant composite comprenant une fibre contenant du carbure de silicium,
un revêtement multicouche incluant un revêtement d'oxyde sur les fibres contenant du carbure de silicium et un revêtement contenant du silicium en contact avec le revêtement d'oxyde pour former une interface, le revêtement contenant du silicium incluant du carbure de silicium, et un silicate formé dans le revêtement contenant du silicium au niveau de l'interface en chauffant les fibres, le revêtement d'oxyde, et le revêtement contenant du silicium à une température prédéterminée entre 800 et 1500 °C de telle sorte qu'une quantité prédéterminée de silicate est produite.

5. Renforcement selon la revendication 4, dans lequel le silicate formé dans le revêtement contenant du silicium au niveau de l'interface du revêtement d'oxyde et du revêtement contenant du silicium inclut du dioxyde de silicium, le revêtement contenant du silicium présente une porosité en volume entre 10 % et 20 %, et le revêtement d'oxyde présente une porosité en volume entre 10 % et 20 %.

6. Procédé pour produire un composant composite comprenant les étapes consistant à
préparer des renforcements en déposant un revêtement d'oxyde et en déposant un revêtement contenant du silicium sur le revêtement d'oxyde, chaque renforcement comprenant des fibres contenant du carbure de silicium, le revêtement d'oxyde étant déposé sur les fibres contenant du carbure de silicium, et le revêtement contenant du silicium inclut du carbure de silicium,
chauffer des renforcements à une température prédéterminée entre 800 et 1500° Celsius pour former une quantité contrôlée de silicate dans le revêtement contenant du silicium au niveau de l'interface du revêtement d'oxyde et du revêtement contenant du silicium, et
suspendre les renforcements dans un matériau de matrice.

7. Procédé selon la revendication 6, dans lequel le chauffage des fibres revêtues à la température prédéterminée pour former une quantité prédéterminée de silicate dans le revêtement contenant du silicium au niveau de l'interface du revêtement d'oxyde et du revêtement contenant du silicium est exécuté pendant plus d'une heure dans un four.

8. Procédé selon l'une quelconque des revendications 6 à 7, dans lequel le matériau de matrice inclut du carbure de silicium.

9. Composant composite comprenant un matériau de matrice, et une pluralité de renforcements, chaque renforcement incluant des fibres contenant du carbure de silicium, un revêtement d'oxyde sur les fibres contenant du carbure de silicium, et un revêtement contenant du silicium incluant du carbure de silicium,
dans lequel le revêtement contenant du silicium est en contact avec le revêtement d'oxyde pour former une interface et un silicate est formé dans le revêtement contenant du silicium au niveau de l'interface par chauffage des fibres, du revêtement d'oxyde, et du revêtement contenant du silicium à une température prédéterminée entre 800 et 1500 °C de telle façon qu'une quantité prédéterminée de silicate est produite.

10. Composant composite selon la revendication 9, dans lequel le silicate formé dans le revêtement contenant du silicium au niveau de l'interface du revêtement d'oxyde et du revêtement contenant du silicium inclut du dioxyde de silicium, le revêtement contenant du silicium présente une porosité en volume entre 10 % et 20 %, et le revêtement d'oxyde présente une porosité en volume entre 10 % et 20 %.

11. Composant composite selon la revendication 9 ou 10, dans lequel le matériau de matrice inclut du carbure de silicium.
